# EUROPEAN PATENT APPLICATION

(11) **EP 1 521 293 A1**
(43) Date of publication of application: **06.04.2005**
(21) Application number: 04018410.3
(22) Date of filing: 03.08.2004
(51) Int. Cl.: H01L 21/00, H01L 21/428, C23C 16/04, C23C 16/18, C23C 16/48, C23C 16/52

(54) **Submicron size metal deposit apparatus**

(30) Priority: 01.10.2003 JP 2003342925
(71) Applicant: Hitachi High-Technologies Corporation, Tokyo 105-8717 (JP)
(72) Inventor: Hidaka, Kishio, Chiyoda-ku, Tokyo 100-8220 (JP); Fujieda, Tadashi, Chiyoda-ku, Tokyo 100-8220 (JP); Hayashibara, Mitsuo, Chiyoda-ku, Tokyo 100-8220 (JP)
(74) Representative: Strehl Schübel-Hopf & Partner

(57) **Abstract**

The method by which a small amount of gaseous organic metal is loaded in a vacuum atmosphere, the gaseous organic metal is decomposed by irradiation with an electron beam, and metal components are deposited on a beam-irradiated portion has the problem that the deposited portion is rendered amorphous by hydrocarbon contamination, so that the conductivity and strength of the deposit considerably deteriorate. The invention solves the problem by a method by which the gaseous organic metal is decomposed by irradiation with the electron beam and the metal components are deposited on the beam-irradiated portion, wherein the deposited portion is irradiated with a laser, heated by a heater, or irradiated with infrared rays during deposition, thereby allowing the molding of a crystalline metal deposit with excellent conductivity and strength.

## Description

### BACKGROUND OF THE INVENTION

### Field of the Invention

The present invention relates to a deposit molding method by which an gaseous organic metal is decomposed by irradiation with an electron beam to form a deposit, and to a submicron size metal deposit apparatus capable of carrying out the molding method.

### Background Art

A method is known whereby, a gaseous organic metal is irradiated with a gallium ion, which is a kind of a charged particle, in order to decompose the same, thereby forming a metal deposit in an irradiated area. Another method of forming a similar metal deposit by electron beam irradiation has also been reported.

For example, it is reported in Digest 30a-YD-4 of the 64th Annual Meeting of the Japan Society of Applied Physics that a dot with a minimum diameter of about 3.5 nm was molded with an electron beam of about 0.8 nm in probe size, using a scanning transmission electron microscope. In this case, the accelerating voltage of the electron beam is 100 kV or more.

Non-Patent Document 1: Kazuo Furuya "Current State of Making of Nanostructures Using a Focused Electron Beam" 30a-YD-4 of the 64th Annual Meeting of the Japan Society of Applied Physics

### SUMMARY OF THE INVENTION

In experiments to mold a metal deposit with the energy of the electron beam ranging from several kV to dozens of kV, although the formation of a metal deposit was confirmed, the metal deposit was amorphous and significantly inferior in conductivity, strength, and weldability. It was also learned that when the amorphous metal deposit was heated after the molding thereof, hydrocarbon that had mixed in reacted with metal to form metal carbide or metal-hydrocarbon compound, so that desired characteristics could not be obtained.

Further, in semiconductor device inspection where devices are inspected using a tungsten probe, the tungsten probe requires frequent replacement because of damage.

A first object of the present invention is to provide a method for obtaining a metal deposit that is superior in conductivity, strength, and weldability.

A second object of the present invention is to provide a method for forming a terminal that is suitable for a conductive probe.

In a first means to achieve the first object, the invention provides a method by which a small amount of gaseous organic metal is filled into a vacuum atmosphere, and the gaseous organic metal is decomposed by irradiation with an electron beam, thereby depositing metal components on a beam-irradiated portion. The deposition is conducted while irradiating the deposited-portion with a laser.

In a second means to achieve the first object, the invention provides a method by which, while a small amount of gaseous organic metal is filled into a vacuum atmosphere, the gaseous organic metal is decomposed by irradiation with an electron beam, and metal components are deposited on a beam-irradiated portion. A heater is brought close to the deposited portion either from above or below a substrate, thereby providing the deposited portion with thermal radiation from the heater.

In a third means to achieve the first object, the invention provides a method by which, while a small amount of gaseous organic metal is filled into a vacuum atmosphere, the gaseous organic metal is decomposed by irradiation with an electron beam, thereby depositing metal components on the beam-irradiated portion. An infrared lamp is disposed above a substrate to provide the metal components with thermal radiation of infrared rays condensed by a concave mirror disposed in the rear of the infrared lamp.

In a fourth means to achieve the first object, the energy of the electron beam is controlled to range from 1 kV to dozens of kV in the first and second means to achieve the first object.

In a first means to achieve the second object, the conductivity of the deposit is controlled to be 1 µA or more in the first and second means to achieve the first object.

In a second means to achieve the second object, the bonding strength of the deposit is controlled to be 1 nN or more, or the deposit is rendered such that it permanently resists deformation, in the first and second means to achieve the first object.

According to the present invention, hydrocarbon contamination can be prevented during the electron beam irradiation, so that a crystalline metal deposit superior in conductivity, strength, and weldability can be molded.

For example, when depositing tungsten by irradiation with an electron beam, a reaction of decomposition, W(CO)₆ → W+6CO↑, is used. It has been learned that if the accelerating voltage of the electron beam is several kV to dozens of kV, the resultant deposit is mainly amorphous, and that this is due to contamination by hydrocarbon residue inside an electron beam apparatus. This problem is solved by a means whereby, in a process of metal deposit molding, crystallization of metal deposition is facilitated while preventing the introduction of hydrogen.

### BRIEF DESCRIPTION OF THE DRAWINGS

Fig. 1 shows a metal deposit molding method using laser irradiation under electron beam irradiation.
Fig. 2 shows a metal deposit molding method using a nearby heater under electron beam irradiation.
Fig. 3 is a crystalline and amorphous region map as a function of the temperature of a heater and the distance between a substrate and the heater.
Fig. 4 shows a deposit molding method using substrate heating by a back heater under electron beam irradiation.
Fig. 5 is a cross section of a transmission electron micrograph of a portion where a metal probe for semiconductor inspection is molded.

### DESCRIPTION OF THE PREFERRED EMBODIMENTS

### Embodiment 1

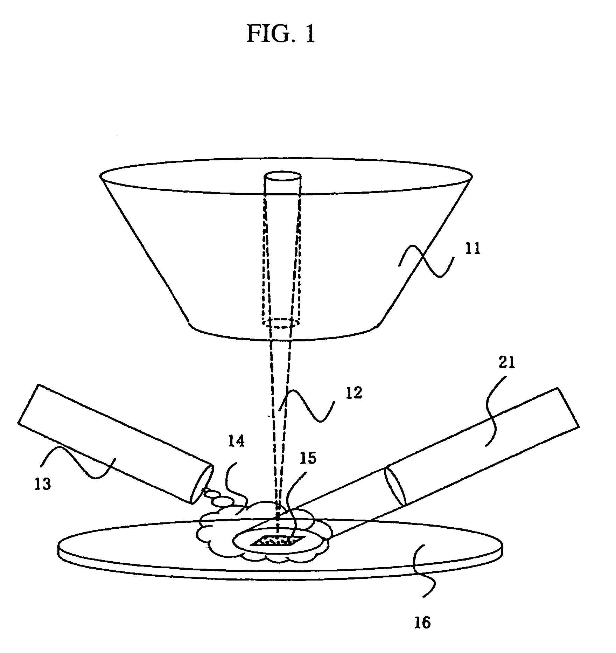

Fig. 1 shows a configuration wherein electrons are emitted from an electron gun and a gaseous organic metal 14 is decomposed by an electron beam 12 that passed through an objective lens 11. An electron-beam-irradiated portion is simultaneously irradiated with a laser from a laser nozzle 21. In this way, a metal deposit 15 is molded while preventing the introduction of hydrocarbon by local heating. In this method, hydrocarbon contamination can be prevented and, in addition, a metal deposit containing crystalline material can be obtained because of the additional energy provided, the deposit exhibiting sound conductivity and weldability. It has also been learned that thermal strain is less likely to occur throughout the entire substrate 16 because the laser irradiation only heats the area around the metal deposit 15 in a concentrated manner.

### Embodiment 2

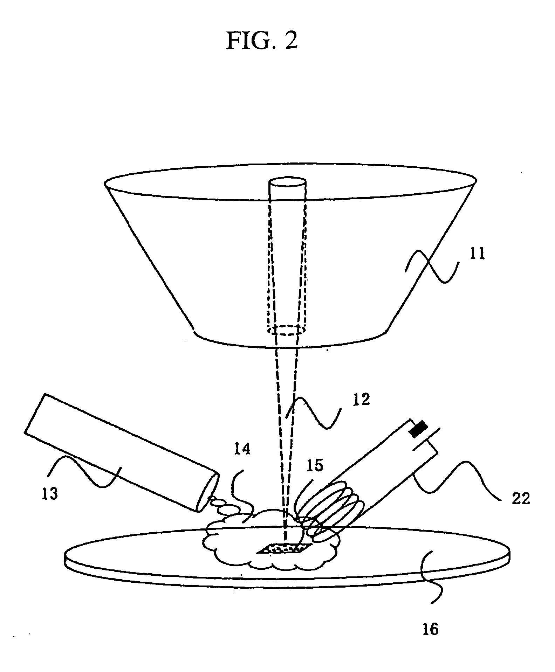

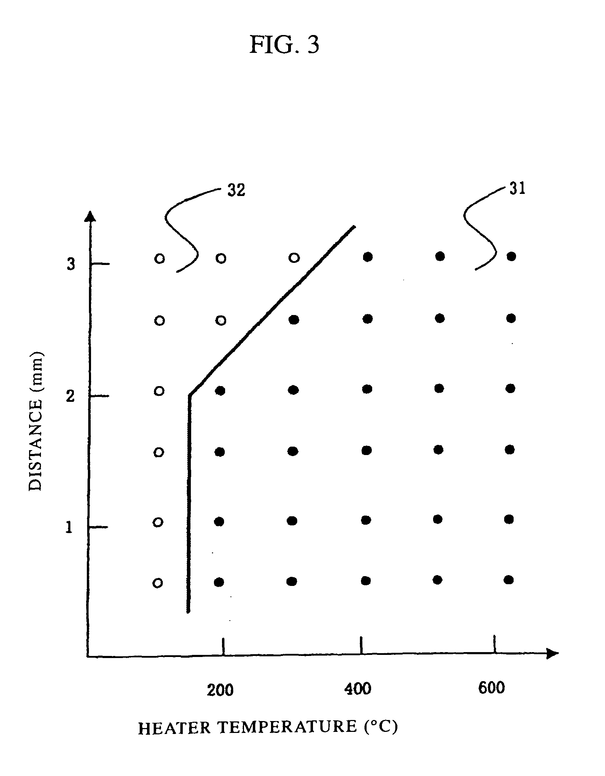

Fig. 2 shows another embodiment wherein a heater 22 is disposed near where the gaseous organic metal 14 is decomposed by the irradiation with the electron beam, so that the metal deposit 15 can be molded while heating the electron-beam-irradiated portion. Fig. 3 shows the temperature of the heater 22, the distance between the heater 22 and a substrate 16, and the crystallinity of the metal deposit 15. Fig. 3 shows a crystalline region 31 and an amorphous region 32. The result indicates that sound conductivity and weldability can be obtained under the condition of the crystalline region 31.

### Embodiment 3

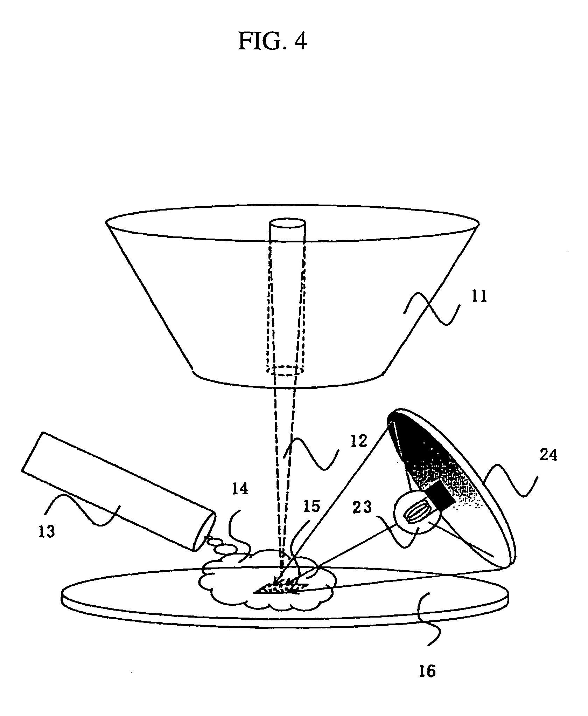

Fig. 4 shows another embodiment wherein an infrared lamp 23 and a collector plate 24 are disposed above a substrate 16 in order to heat the substrate 16. It has been learned that in this configuration, too, hydrocarbon contamination can be prevented as long as the temperature of the surface with which the metal deposit is in contact is about 130 °C or higher.

### Embodiment 4

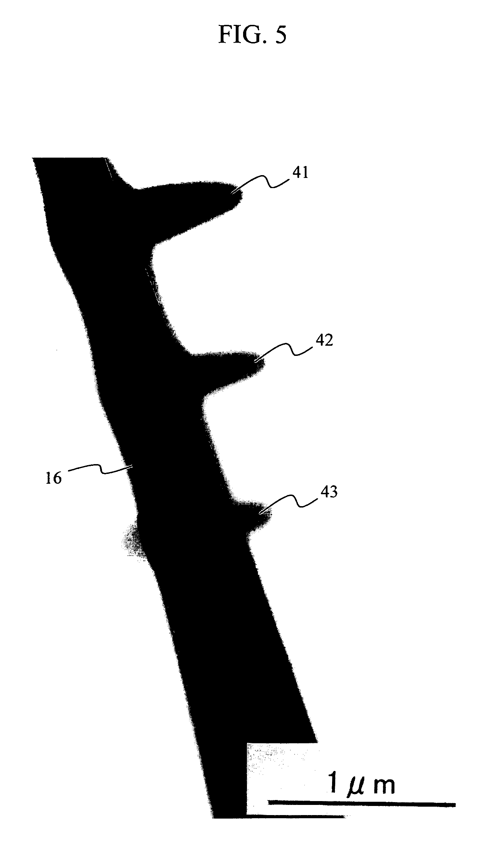

Fig. 5 is a cross section of a transmission electron micrograph of a metal-deposited portion. It shows the metal deposit molded by varying the electron beam irradiation time to 120 seconds (41), 60 seconds (42), and 30 seconds (43). The growth rate of the deposit was virtually constant. An energy spectrum of tungsten was obtained when a point analysis was conducted using an energy dispersive spectrum analyzer attached with the transmission electron microscope. Also, a good conductivity of 1 µA or more was obtained. A marking evaluation was conducted using a cantilever of an atomic force microscope, involving a load of 1 µN placed on a 250-nm square metal deposit molded on an Si substrate by the same method. No evidence of marking was found.

## Claims

1. A submicron size metal deposit apparatus for a method comprising loading a small amount of gaseous organic metal in a vacuum atmosphere, decomposing said gaseous organic metal by irradiating it with an electron beam, and depositing metal components on the beam-irradiated portion, wherein the deposition is conducted while irradiating the deposited portion with a laser.

2. A submicron size metal deposit apparatus for a method comprising loading a small amount of gaseous organic metal in a vacuum atmosphere, decomposing said gaseous organic metal by irradiating it with an electron beam, and depositing metal components on the beam-irradiated portion, wherein a heater is brought near the deposited portion either from above or below a substrate such that the deposition can be conducted while providing thermal radiation to it from said heater.

3. A submicron size metal deposit apparatus for a method comprising loading a small amount of gaseous organic metal in a vacuum atmosphere, decomposing said gaseous organic metal by irradiating it with an electron beam, and depositing metal components on the beam-irradiated portion, wherein thermal radiation emitted from an infrared lamp is condensed and provided at the deposited portion during deposition.

4. The submicron size metal deposit apparatus according to claim 1, wherein the voltage of the electron beam is in the range between 1 kV and dozens of kV.

5. A manufacturing method and a submicron size metal deposit apparatus according to claim 1, wherein the conductivity of the deposit is not less than 1 µA.

6. A manufacturing method and a submicron size metal deposit apparatus according to claim 5, wherein the deposit shows no evidence of marking when a load of 1 nN or more is applied.
